# EUROPEAN PATENT SPECIFICATION

(11) **EP 1 361 580 B1**
(45) Date of publication and mention of the grant of the patent: **01.07.2009**
(21) Application number: 03016398.4
(22) Date of filing: 27.09.2000
(51) Int. Cl.: G11C 5/14, G11C 11/406

(54) **Semiconductor memory device, and method of controlling the same**
Halbleieterspeicheranordnung und zugehöriges Steuerungsverfahren
Dispositif de mémoire à semiconducteurs et sa méthode de commande

(30) Priority: 09.11.1999 JP 31845899; 09.08.2000 JP 2000241019
(43) Date of publication of application: 12.11.2003
(62) Divisional of application: 00308482.9
(73) Proprietor: Fujitsu Microelectronics Limited, Tokyo 163-0722 (JP)
(72) Inventor: Fujioka, Shinya, c/o Fujitsu Limited, Kawasaki-shi, Kanagawa 211-8588 (JP); Kawakubo, Tomohiro, c/o Fujitsu Limited, Kawasaki-shi, Kanagawa 211-8588 (JP); Nishimura, Koichi, c/o Fujitsu Limited, Kawasaki-shi, Kanagawa 211-8588 (JP); Sato, Kotoku, c/o Fujitsu Limited, Kawasaki-shi, Kanagawa 211-8588 (JP)
(74) Representative: Hitching, Peter Matthew

(56) References cited:
- US-A- 5 197 026

## Description

The present invention relates to a semiconductor memory device having a low power consumption mode.

In recent years, the cellular phone has been given not only a function to have a vocal communication but also a function to transmit character-string data or image data. Moreover, the cellular phone is expected in the future to become a kind of information terminal (for example, a portable type personal computer) as the internet services are diversified. Thus, the information volume of data to be handled by the cellular phone has been drastically increasing. Typically, the cellular phone has employed as its work memory SRAMs having a memory capacity of about 4 Mbit. The work memory is a memory for retaining the necessary data during the operation of the cellular phone. It is probable that the memory capacity of this work memory will be insufficient in the future.

In addition, the transmission speed of the cellular phone has been increasing. The smaller the cellular phone becomes, the smaller the battery to be mounted becomes. Therefore, the work memory to be employed in the cellular phone is required to have a high speed, a low power consumption and a large capacity. Due to serious price competition in the cellular phone market, it is necessary to make the costs for parts as low as possible. Therefore, the work memory also has to be at low price.

The SRAMs employed in the work memory of previously-considered cellular phones are higher per bit in cost than DRAMs. The number of SRAMs produced is smaller than that of the DRAMs so that it is difficult to lower its price. Moreover, there have never been developed SRAMs having a large memory capacity (for example, 64 Mbit).

In this situation, it has been considered to replace the SRAMs by flash memories and DRAMs in the work memory of the cellular phone.

The flash memory has a power consumption as low as several µW during a standby state but requires several µs to several tens µs for writing data. When the flash memory is employed as the work memory of the cellular phone, therefore, it is difficult to transmit/receive massive data at high speed. The flash memory performs the write operation at the unit of a sector so that it is not suitable for rewriting image data, such as the data of a moving image, bit by bit.

On the contrary, the DRAMs can execute both the read operation and the write operation within several tens ns and can process the data of the moving image easily. However, the power consumption during the standby state is higher than that of the flash memories. In the present DRAMs, the power consumption in the standby state is about 1 mW during a self-refresh mode for retaining written data and about 300 W during a standby mode not required for retaining written data.

If the power consumption during the standby mode could be reduced to that of the flash memories, the DRAMs could be employed as the work memory of the cellular phone, but such circuit technology has never been proposed.

The power consumption of the DRAMs can be reduced to zero by stopping the power supply to the DRAMs. However, since the address terminals, the data terminals and the like of the DRAMs are connected with the terminals of other electronic parts through the wiring patterns on a circuit board, it is required to drastically change the system of the cellular phone (the pattern change of the circuit board, re-layout and so on) for the termination of the power supply to the DRAMs.

Besides, there has not been proposed a technology which realizes exit from the standby mode without the malfunction of an internal circuit after the power supply is terminated to stop the operation of the internal circuit during the standby mode.

US 5 557 777 discloses a computer system for system recovery from power loss including a central processing unit and an activation means for starting up the computer. The computer system also has a cold boot circuit, a system controller, volatile read/write memory, and non-volatile read/write memory. The controller includes a protection register whose value indicates the manner in which the computer system was previously shut-down. A method for an orderly shut-down includes the steps of compressing all critical data stored in volatile read/write memory, transferring the compressed critical data into non-volatile read/write memory, writing memory validity data to indicate a successful store and the time and date stored, and shutting down the system. Another aspect is a method for system recovery which includes the steps of utilizing the protection register and memory validity data to both recover system and user data if possible and perform only the necessary start-up steps, and setting the protection register to indicate that an orderly shut-down has not occurred.

It is therefore desirable to be able to enter the device into a low power consumption mode and exit the device from a low power consumption mode with reliability.

It is also desirable to provide a semiconductor memory device capable of drastically reducing current consumption during standby mode as compared with the previously-considered devices and a method of controlling the semiconductor memory device.

It is also desirable to provide a semiconductor memory device capable of drastically reducing current consumption during a standby period as compared with the conventional devices and a method of controlling the semiconductor memory device.

The invention is defined by the independent claims. Optional features are set out in the dependent claims.

There may be provided a semiconductor memory device having an internal voltage generator which, when activated, generates an internal voltage to be supplied to an internal circuit. When the internal voltage generator is operated, a predetermined amount of electric power is consumed. In response to a control signal from the exterior, an entry circuit inactivates the internal voltage generator. The internal voltage is not to be generated due to the inactivation of the internal voltage generator so that the power consumption may be reduced. In response to the control signal from the exterior, therefore, it is possible to easily enter the device into the low power consumption mode.

In response to the control signal from the exterior, the entry circuit may stop the operation of a booster and the generation of a boost voltage to be supplied to a word line. During the low power consumption mode the booster steadily consuming the electric power stops so that the power consumption is drastically reduced.

In response to the control signal from the exterior, the entry circuit may stop the operation of a substrate voltage generator to stop the generation of a substrate voltage to be supplied to a substrate. During the low power consumption mode, the substrate voltage generator steadily consuming the electric power stops so that the power consumption is drastically reduced.

In response to the control signal from the exterior, the entry circuit may stop the operation of an internal supply voltage generator to stop the generation of an internal supply voltage to be supplied to a memory core. During the low power consumption mode, the internal supply voltage generator steadily consuming the electric power stops so that the power consumption is drastically reduced.

In response to the control signal from the exterior, the entry circuit may stop the operation of a precharging voltage generator to stop the generation of a precharging voltage to be supplied to bit lines. During the low power consumption mode, the precharging voltage generator steadily consuming the electric power stops so that the power consumption is drastically reduced.

An external voltage supplying circuit may supply the power supply voltage as the internal voltage to the internal circuit during the low power consumption mode. When the internal voltage generating circuit is inactive, therefore, the power supply terminal of each internal circuit is supplied with a predetermined power supply voltage. As a result, each element of the internal circuit is fixed in a predetermined state to prevent a leak path. In other words, the flow of a feedthrough current is prevented.

A predetermined internal circuit may be inactivated when a reset signal is supplied from the exterior. In response to this reset signal, the entry circuit enters the device into the low power consumption mode. During the resetting, the device need not be operated. Therefore, it can enter the low power consumption mode by utilizing the existing signal. The type and number of external terminals are identical to those of the conventional terminals so that adding the low power consumption mode does not lower the usability.

The entry circuit may receive a plurality of control signals from the exterior. The entry circuit enters the device into the low power consumption mode when it recognizes the states of the control signals as low power consumption commands. Therefore, the device can enter the low power consumption mode by the command input.

The entry circuit may receive a reset signal and a chip enable signal from the exterior. The entry circuit enters the device into the low power consumption mode when it recognizes the states of those control signals as low power consumption commands. Therefore, the device can enter the low power consumption mode by the command input.

The device may enter the low power consumption mode when the reset signal is inactivated during a predetermined period and in this state the chip enable signal is activated during a predetermined period. Even when a glitch occurs in the reset signal or the chip enable signal due to power supply noises or the like, it is able to prevent the device from erroneously entering the low power consumption mode.

The entry circuit may receive a plurality of control signals from the exterior during the low power consumption mode. The entry circuit exits the device from the low power consumption mode when the levels of the control signals indicate exit of the low power consumption mode. Therefore, the device can be exited from the low power consumption mode by the command input.

The entry circuit preferably enters the device into the low power consumption mode when it receives the predetermined level or the transition edge of a low power consumption mode signal. Therefore, the device can reliably enter the low power consumption mode by employing a dedicated signal.

There may be provided a semiconductor memory device and method of controlling the semiconductor memory device, in which, when the state of a control signal received during the low power consumption mode indicates exit of the low power consumption mode, the low power consumption mode is exited. This allows the device to be easily exited from the low power consumption mode by a control signal from the exterior. The exist from the low power consumption mode is, for example, executed by controlling the entry circuit.

After the low power consumption mode is exited, a reset signal for initializing an internal circuit may be activated during a period where the internal voltage is lower than a predetermined voltage. For instance, the reset signal is activated during a period where the internal voltage is lower than a reference voltage generated by stepping down the power supply voltage. Therefore, when the low power consumption mode shifts to a normal operating mode, the internal circuit can be reliably reset, which prevents malfunction of the internal circuit.

After the low power consumption mode is exited, a reset signal for initializing an internal circuit may be activated during a period where a boost voltage internally generated is lower than a predetermined voltage. For example, the reset signal is activated during a period where the boost voltage is lower than the power supply voltage. In addition, the reset signal can be activated during a period where the boost voltage is lower than a reference voltage generated by stepping down the power supply voltage.

After the low power consumption mode is exited, a reset signal for initializing an internal circuit may be activated during a period where at least one of the internal voltage and a boost voltage internally generated is/are lower than respective predetermined voltages. Therefore, when the low power consumption mode shifts to the normal operating mode, the internal circuit can be reliably reset, which prevents malfunction of the internal circuit.

At the time of the exit form the low power consumption mode, while a timer is measuring a predetermined length of time, a reset signal for initializing an internal circuit may be activated. This allows reliable reset of the internal circuit, leading to preventing malfunction of the internal circuit when the low power consumption mode shifts to a normal operating mode.

A timer may include a CR time constant circuit. The timer measures the length of a time based on the propagation delay time of a signal propagated to the CR time constant circuit so that the activation period of a reset signal can be set by a simple circuit.

At the time of the exit from the low power consumption mode, a reset signal for initializing an internal circuit may be activated while a counter operating in the normal operation counts a predetermined number. This allows reliable reset of the internal circuit, leading to preventing malfunction of the internal circuit when the low power consumption mode shifts to a normal operating mode. For example, a refresh counter for indicating the refresh address of memory cells or the like is employed as a counter.

There may be provided a method of controlling a semiconductor memory device having an internal voltage generator which, when activated, generates the internal voltage to be supplied to a predetermined internal circuit. When the internal voltage generator is operated, a predetermined amount of electric power is consumed. In response to the control signal from the exterior, the internal voltage generator is inactivated. The internal voltage is not to be generated due to the inactivation of the internal voltage, which results in reducing the power consumption. In response to the control signal from the exterior, therefore, the device can easily enter the low power consumption mode.

A plurality of control signals may be received from the exterior. The device enters the low power consumption mode when it recognizes the states of the control signals as the low power consumption commands. Therefore, the device can enter the low power consumption mode by the command input.

When the power supply is switched on, the chip enable signal may remain inactivated until the power supply voltage reaches a predetermined voltage. This makes it possible to prevent an erroneous entry to the low power consumption mode when the power supply is switched on.

A semiconductor memory device, and a method of controlling the device, as described above can offer one or more of the following advantages:
It is possible to easily enter a device into a low power consumption mode by a control signal from the exterior.

It is possible to prevent the feedthrough current (or leak path) of an internal circuit during a lower power consumption mode.

It is possible to easily enter the device into the low power consumption mode by employing an existing control signal.

It is possible to easily enter the device into the low power consumption mode by a command input.

It is possible to easily enter the device into the low power consumption mode by a dedicated control signal.

Reference will now be made, by way of example, to the accompanying drawings, in which:
Fig. 1 is a state transition diagram of a semiconductor memory device embodying the present invention;
Fig. 2 is a block diagram showing a basic principle of a first embodiment;
Fig. 3 is a block diagram showing the first embodiment;
Fig. 4 is a circuit diagram showing the details of a booster and a precharging voltage generator of Fig. 3;
Fig. 5 is a circuit diagram showing the details of an internal supply voltage generator and a substrate voltage generator of Fig. 3;
Fig. 6 is a circuit diagram showing the detail of a portion of a memory core of Fig. 3;
Fig. 7 is a timing chart showing the operations of the first embodiment at the switch-on of a power supply and at the times of entry into and exit from a low power consumption mode;
Fig. 8 is a block diagram showing an example in which the semiconductor memory device of the first embodiment is used in a cellular phone;
Fig. 9 is an explanatory diagram showing the state of using the cellular phone shown in Fig. 8;
Fig. 10 is a flow chart showing the state of controlling the cellular phone shown in Fig. 8;
Fig. 11 is a block diagram showing a second embodiment;
Fig. 12 is a circuit diagram showing the detail of a low power entry circuit of Fig. 11;
Fig. 13 is a timing chart showing the operations of the low power entry circuit of Fig. 12;
Fig. 14 is a block diagram showing a third embodiment;
Fig. 15 is a circuit diagram showing a VII starter in a fourth embodiment;
Fig. 16 is a circuit diagram showing a VII starter in the fourth embodiment;
Fig. 17 is a timing chart showing operations at the entry to and the exit from a low power consumption mode in the fourth embodiment;
Fig. 18 is a circuit diagram showing a level detecting circuit in a fifth embodiment;
Fig. 19 is a timing chart showing operations at the entry to and the exit from a low power consumption mode in the fifth embodiment;
Fig. 20 is a circuit diagram showing a start signal generator in a sixth embodiment; and
Fig. 21 is a timing chart showing operations at the entry to and the exit from a low power consumption mode in the sixth embodiment.

Embodiments of the present invention will be described with reference to the accompanying drawings.

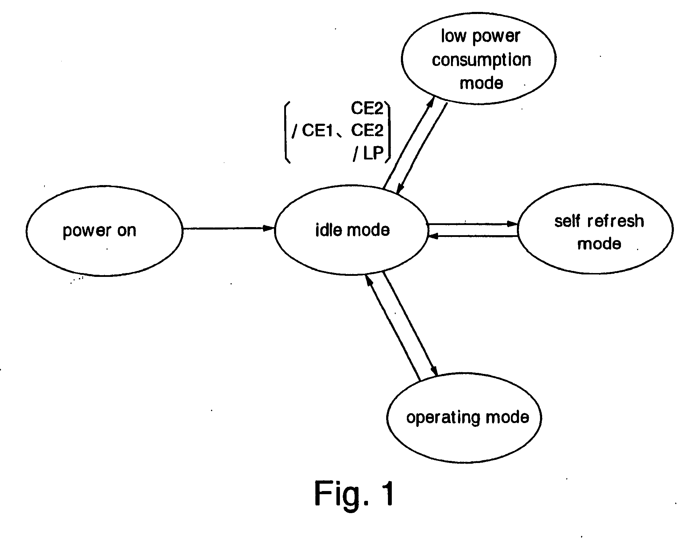

Fig. 1 shows a state transition diagram of a semiconductor memory device embodying the present invention.

First of all, the semiconductor memory device comes into an idle mode when the power supply is switched on. When a read command or a write command is received in the idle mode, the mode shifts to an operating mode to execute a read operation or a write operation. After the execution of the read operation or the write operation, the idle mode is automatically restored. When a self-refreshing command is received in the idle mode, the device enters the self-refreshing mode to execute self refresh. Herein the self-refreshing mode, a refresh address is automatically generated to sequentially execute refreshing operations in memory cells.

The semiconductor memory device enters the low power consumption mode by detecting a predetermined state of a signal in the idle mode. In a first embodiment described below, in response to a chip enable signal CE2, the device enters the low power consumption mode. Specifically, by the chip enable signal CE2 a predetermined internal circuit is inactivated and the device enters the low power consumption mode. In a second embodiment described below, in response to a command input by chip enable signals /CE1 and CE2, the device enters the low power consumption mode. In a third embodiment described below, in response to a dedicated low power consumption mode signal /LP, the device enters the low power consumption mode.

The semiconductor memory device detects a predetermined state of a signal during the low power consumption mode and exits the mode.

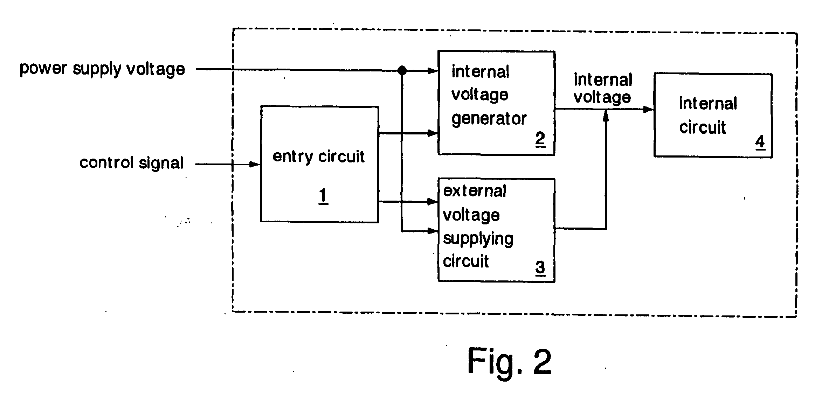

Fig. 2 shows the basic principle of a semiconductor memory device embodying the present invention.

The semiconductor memory device includes an entry circuit 1, an internal voltage generator 2, an external voltage supplying circuit 3 and an internal circuit 4.

The internal voltage generator 2 generates an internal voltage in each mode after the power supply is switched on, and supplies the internal voltage to the internal circuit 4. The entry circuit 1 receives a control signal and inactivates the internal voltage generator 2 when it detects a predetermined state of the control signal. When the internal voltage generator 2 is inactivated, the generation of the internal voltage is stopped. At the same time, the entry circuit 1 activates the external voltage supplying circuit 3. This external voltage supplying circuit 3 supplies the power supply voltage as the internal voltage to the internal circuit 4. And, the semiconductor memory device enters the low power consumption mode.

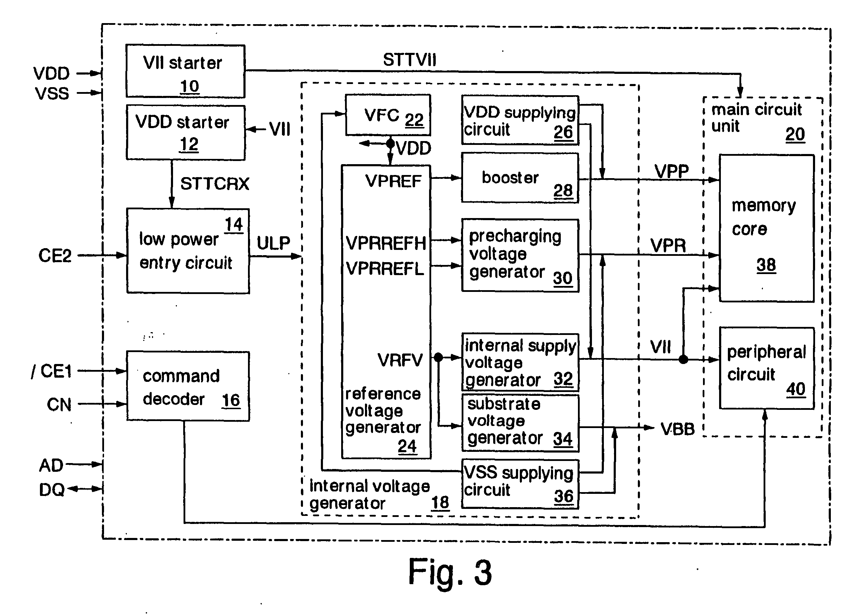

Fig. 3 shows a first embodiment of the semiconductor memory device and its control method of the present invention. The semiconductor memory device of this embodiment is formed as a DRAM on a p-type silicon substrate by employing the CMOS process technology.

The DRAM is provided with a VII starter 10, a VDD starter 12, a low power entry circuit 14, a command decoder 16, an internal voltage generator 18 and a main circuit unit 20. The internal voltage generator 18 has a low-pass filter 22, a reference voltage generator 24, a VDD supplying circuit 26, a booster 28, a precharging voltage generator 30, an internal supply voltage generator 32, a substrate voltage generator 34 and a VSS supplying circuit 36. The main circuit unit 20 has a memory core 38 and a peripheral circuit 40. Here, the low power entry circuit 14 corresponds to the entry circuit 1 shown in Fig. 2, and the VDD supplying circuit 26 and the VSS supplying circuit 36 correspond to the external voltage supplying circuit 3 shown in Fig. 2.

The DRAM is supplied with a power supply voltage VDD (e.g., 2.5 V) from the exterior, a ground voltage VSS, chip enable signals /CE1 and CE2 as the control signals, a plurality of address signal AD, a plurality of data input/output signals DQ, and another control signal CN. This DRAM does not adopt the address multiplex method. Therefore, the address signals AD is supplied once at each read operation and at each write operation. The power supply voltage VDD and the ground voltage VSS are supplied to almost all the circuits excepting a partial circuit of the memory core 38. Here, the signals headed by the letter "/" are those of negative logic. The "address signals AD" may be abbreviated into the "AD signals" in the following description by omitting its signal name.

The /CE1 signal is turned to a low level when the read operation and the write operation are executed to activate the DRAM. The CE2 signal functions as a reset signal to inactivate a predetermined internal circuit in the main circuit unit 20 when at the low level.

The VII starter 10 receives the internal supply voltage VII and the ground voltage VSS and outputs a start signal STTVII to the main circuit unit 20. The VII starter 10 is resets the main circuit unit 20 after the power supply is switched on until the internal supply voltage VII reaches a predetermined voltage, and it prevents the malfunction of the main circuit unit 20. The VDD starter 12 receives the power supply voltage VDD and the ground voltage VSS and outputs a start signal STTCRX. The VDD starter 12 inactivates the low power entry circuit 14 after the power supply is switched on until the power supply voltage VDD reaches a predetermined voltage and it prevents the malfunction of the circuit 14.

The low power entry circuit 14 receives the start signal STTCRX and the CE2 signal and activates a low power signal ULP.

In response to the /CE1 signal and another control signal CN, the command decoder 16 decodes a command and outputs the decoded command as an internal command signal to the peripheral circuit 40.

The low-pass filter 22 has a function to filter out the noise contained in the power supply voltage VDD. The power supply voltage VDD thus cleared of the noise is fed to the reference voltage generator 24 or the like. In the low power consumption mode, the switch in the low-pass filter 22 is switched off and the power supply voltage VDD is not supplied to the reference voltage generator 24 so that the current is not consumed.

The reference voltage generator 24 receives the power supply voltage VDD and generates reference voltages VPREF (e.g., 1.5 V), VPRREFL (e.g., 0.8 V), VPRREFH (e.g., 1.2 V) and VRFV (e.g., 2.0 V).

The VDD supplying circuit 26 turns a boost voltage VPP and an internal supply voltage VII to the power supply voltage VDD during the low power consumption mode.

The booster 28 receives the reference voltage VPREF and generates the boost voltage VPP (e.g., 3.7 V) and supplies the boost voltage VPP to the memory core 38.

The precharging voltage generator 30 receives the reference voltage VPRREFL and the reference voltage VPRREFH and generates a precharging voltage VPR (e.g., 1.0 V) to be supplied to the memory core 38.

The internal supply voltage generator 32 receives the reference voltage VRFV and generates the internal supply voltage VII (e.g., 2.0 V) to be supplied to the memory core 38 and the peripheral circuit 40.

The substrate voltage generator 34 receives the reference voltage VRFV and generates a substrate voltage VBB (e.g., -1.0 V) to be fed to the substrate and the p-wells of the memory cells.

The VSS supplying circuit 36 turns the precharging voltage VPR and the substrate voltage VBB to the ground voltage VSS during the low power consumption mode.

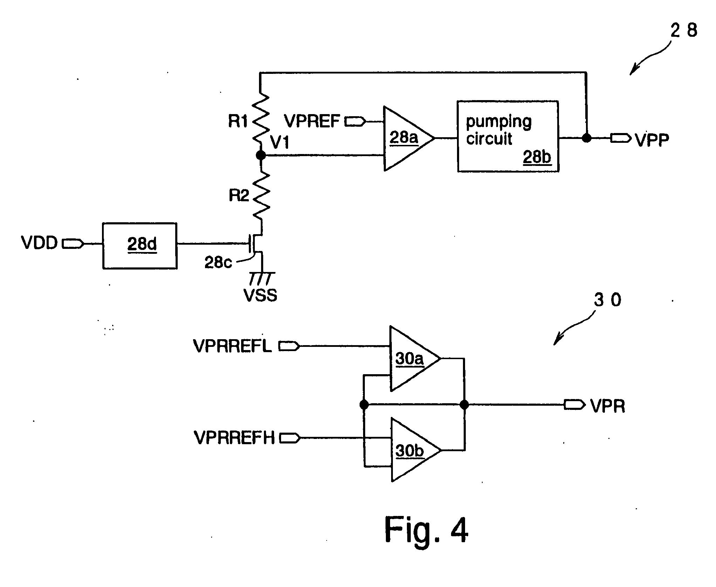

Fig. 4 shows the details of the booster 28 and the precharging voltage generator 30.

The booster 28 is composed of resistors R1 and R2 connected in series, a differential amplifier 28a, a pumping circuit 28b, an nMOS 28c and a switching circuit 28d for controlling the gate of the nMOS 28c. The resistor R1 is supplied at its one end with the boost voltage VPP, and the resistor R2 is supplied at its one end with the ground voltage VSS through the nMOS 28c. A divided voltage V1 is generated from the connection node of the resistors R1 and R2. The nMOS 28c receives the power supply voltage VDD from the switching circuit 28d during the low power consumption mode. The differential amplifier 28a is formed of a MOS differential amplifier using a current mirror circuit, for example, as the current source. The differential amplifier 28a outputs a high level when the voltage V1 is lower than the reference voltage VPREF. The pumping circuit 28b receives the high level from the differential amplifier 28a and starts a pumping operation. By this pumping operation, the voltage VPP is raised, and the voltage V1 is raised. When this voltage V1 coincides with the reference voltage VPREF (i.e., 1.5 V), the output of the differential amplifier 28a reaches the low level so that the pumping operation stops. By repeating these operations, the boost voltage VPP is retained at a constant voltage.

The precharging voltage generator 30 is composed of two differential amplifiers 30a and 30b connected at their outputs with each other. The differential amplifier 30a is supplied with the reference potential VPRREFL and the precharging voltage VPR. The differential amplifier 30b is supplied with the reference potential VPRREFL and the precharging voltage VPR. Moreover, these differential amplifiers 30a and 30b generate the precharging voltage VPR at an intermediate value between the reference voltages VPRREFL and VPRREFH.

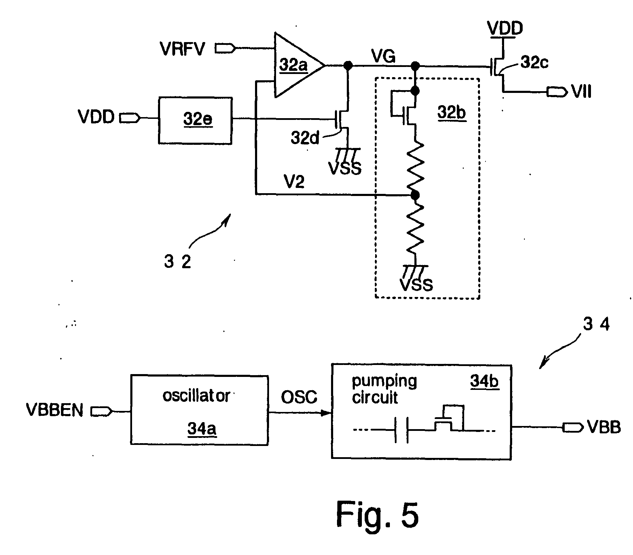

Fig. 5 shows the details of the internal supply voltage generator 32 and the substrate voltage generator 34. The internal supply voltage generator 32 is composed of a negative feedback type differential amplifier 32a, a compensating circuit 32b, a regulator 32c made of an nMOS, an nMOS 32d, and a switching circuit 32e for controlling the gate of the nMOS. The differential amplifier 32a receives the reference voltage VRFV and a voltage V2 generated by the compensating circuit 32b, and supplies a predetermined voltage to a node VG. In the compensating circuit 32b, an nMOS and resistors R3 and R4 in a diode connection are arranged in series between the node VG and the ground line VSS. The voltage V2 is generated at the connection node between the resistors R3 and R4. The regulator 32c is connected at its gate with the node VG, receives the power supply voltage VDD at its drain and generates the internal supply voltage VII at its source.

The nMOS 32d is grounded at its source and connected at its drain with the node VG. The switching circuit 32e supplies the power supply voltage VDD to a gate of the nMOS 32d during the lower power consumption mode. The nMOS 32d receives the power supply voltage VDD from the switching circuit 32e during the low power consumption mode, and fixes the node VG at the ground level.

In this internal supply voltage generator 32, when the threshold voltage of the regulator 32c is lowered due to the rise in the ambient temperature, for example, the threshold voltage of the nMOS of the compensating circuit 32b also drops, so that the voltage V2 rises. In response to the rise in the voltage V2, the differential amplifier 32a lowers the voltage of the node VG. Moreover, the source-to-drain current of the nMOS 32c is made constant so that the internal supply voltage VII is made constant.

The substrate voltage generator 34 is composed of an oscillator 34a and a pumping circuit 34b. In response to the high level of a control signal VBBEN, the oscillator 34a starts the oscillating operation to output an oscillating signal OSC. The pumping circuit 34b has a capacitor for repeating charge and discharge in response to the oscillating signal OSC from the oscillator 34a, and a diode-connected nMOS transistor connected with one end of the capacitor. The charges of a p-type substrate connected with the anode are discharged by the pumping operation, which lowers the substrate voltage VBB. Making the substrate voltage VBB negative leads to gaining some effects such as reducing the influences of a shift in the threshold voltage of the memory cells due to the substrate effect so that the characteristics of the memory cells may be improved.

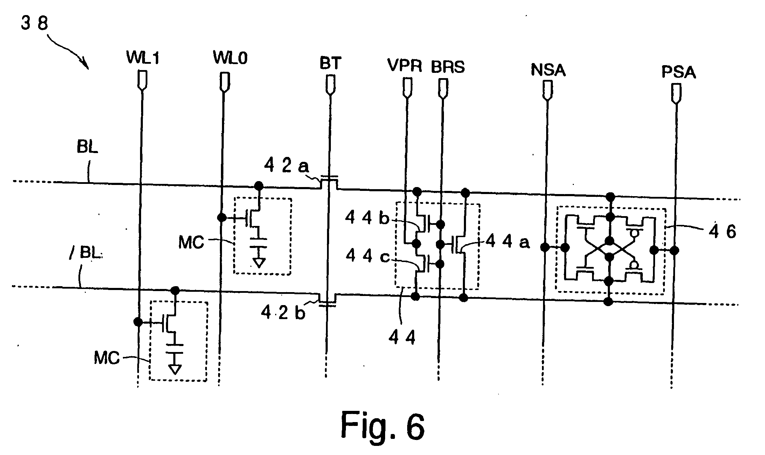

Fig. 6 shows the detail of a portion of the memory core 38.

The memory core 38 has a memory cell MC, nMOS switches 42a and 42b, a precharging circuit 44 and a sense amplifier 46.

The memory cell MC is composed of a data transferring nMOS and a capacitor. The gate of the nMOS is connected with a word line WL0 (or WL1).

The nMOS switches 42a and 42b control the connection between a bit line BL (or /BL) on the side of the memory cell MC and a bit line BL (or /BL) on the side of a sense amplifier SA. The nMOS switches 42a and 42b receive a control signal BT at their gates.

The precharging circuit 44 is composed of three nMOSes 44a, 44b and 44c. The nMOS 44a is connected at its source and drain, respectively, with the bit lines BL and /BL. The nMOSes 44b and 44c are connected at one of their sources and drains, respectively, with the bit lines BL and /BL, and are supplied at their others with the precharging voltage VPR. The nMOSes 44a and 44b and 44c receive a bit line control signal BRS at their gates.

The sense amplifier 46 is constructed by connecting the inputs and outputs of two CMOS inverters with each other. Each of these CMOS inverters is connected at its outputs individually with the bit lines /BL and BL. The source of the pMOS and the source of the nMOS of each CMOS inverter are connected with power supply lines PSA and NSA, respectively. The voltages of these power supply lines PSA and NSA individually reach the VPR level during a standby state and during the inactivation of the sense amplifiers, and respectively change to the internal supply voltage VII and the ground voltage VSS when the bit lines are amplified.

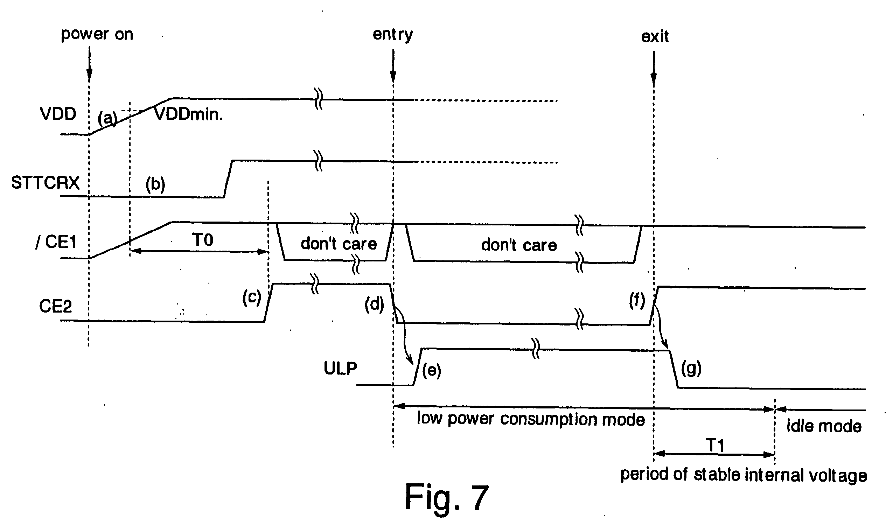

Fig. 7 shows the operations of the switch-on of the power supply, the shifting (entry) to the low power consumption mode, and the release (exit) from the low power consumption mode with regard to the aforementioned semiconductor memory device.

First of all, when the power supply is switched on, the power supply voltage VDD rises gradually (Fig. 7(a)). The VDD starter 12 shown in Fig. 3 inactivates the start signal STTCRX (to the low level) till the power supply voltage VDD reaches a predetermined voltage (Fig. 7(b)). By this control, it is possible to prevent the ULP signal from being activated due to the malfunctioning of the low power entry circuit 14 when the power supply is switched on. An exterior controller (e.g., a CPU or a memory controller) for controlling the DRAM turns the CE2 signal at the high level a predetermined time T0 after the power supply voltage VDD reaches the minimum operable voltage VDDmin (Fig. 7(c)).

After this, the DRAM becomes the standby state or executes an ordinary operation. The exterior controller turns the CE2 signal to the low level when the DRAM enters the low power consumption mode (Fig. 7(d)). The low power entry circuit 14 activates the ULP signal (to the high level) in response to the fall of the CE2 signal when the STTCRX signal is at the high level (Fig. 7(e)).

In response to the high level of the ULP signal, the low-pass filter 22 of the internal voltage generator 18 stops the supply of the power supply voltage to the reference voltage generator 24 and instead supplies the ground voltage VSS from the VSS supplying circuit 36. In response to the ground voltage VSS, the reference voltage generator 24 turns the reference voltages VPREF, VPRREFL, VPRREFH and VRFV to the ground level. The nMOS 28b of the booster 28 shown in Fig. 4 and the nMOS 32d of the internal supply voltage generator 32 shown in Fig. 5 are switched off. As a result, the booster 28, the precharging voltage generator 30, the internal supply voltage generator 32 and the substrate voltage generator 34 are inactivated to stop their operations. Thus, all the conventional circuits remaining operative during the low power consumption mode are stopped. Therefore, the power consumption in the low power consumption mode is drastically reduced as compared with the conventional.

When these circuits are inactivated, the generations of the boost voltage VPP, the precharging voltage VPR, the internal supply voltage VII and the substrate voltage VBB are stopped. However, the boost voltage VPP and the internal supply voltage VII are changed into the power supply voltage VDD by the VSS supplying circuit 36, and the substrate voltage VBB and the precharging circuit VPR are changed into the ground voltage VSS by the VSS supplying circuit 36. Therefore, the internal circuit of the main circuit unit 20 is prevented from having a leak path.

The exterior controller turns the CE2 signal to the high level when the low power consumption mode is released (Fig. 7(f)). In response to the high level of the CE2 signal, the low power entry circuit 14 inactivates the ULP signal (to the low level) (Fig. 7(g)). In response to the inactivation of the ULP signal, the low-pass filter 22 supplies the power supply voltage VDD to the reference voltage generator 24. In response to the inactivation of the ULP signal, the VDD supplying circuit 26 and the VSS supplying circuit 36 stop the supplies of the power supply voltage VDD and the ground voltage VSS. Then, the booster 28, the precharging voltage generator 30, the internal supply voltage generator 32 and the substrate voltage generator 34 are activated again to start their operations.

Here, the DRAM enters the idle mode a time T1 after the high level of the CE2 signal. This time T1 is a time required for the individual internal voltages VPP, VPR, VII and VBB to become stable.

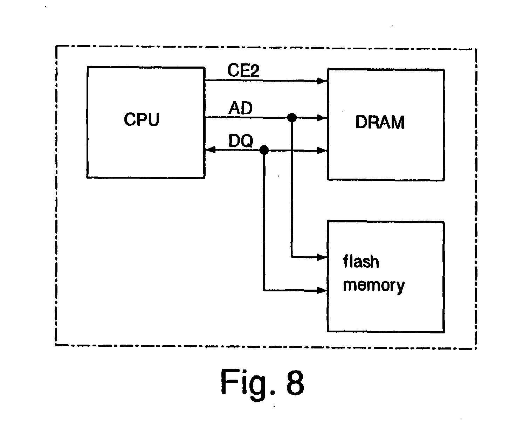

Fig. 8 shows an example in which the semiconductor memory device of the first embodiment is employed in a cellular phone.

This cellular phone has the DRAM of this embodiment, the CPU and the flash memory mounted on the circuit board.

The CPU controls the read/write operation of the data from/in the DRAM and the flash memory. The DRAM is employed as the work memory, and the flash memory is employed as the backup memory when the cellular phone is switched off or in the waiting state.

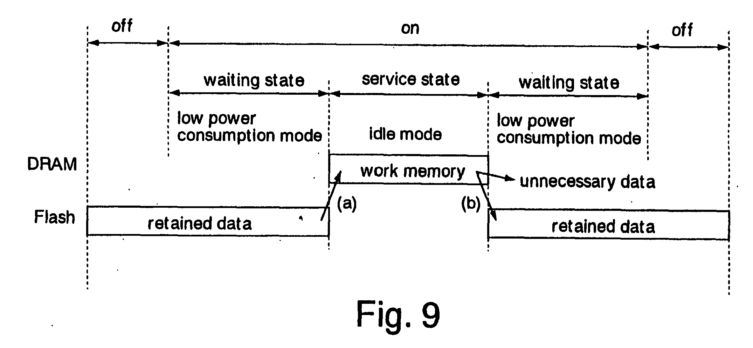

Fig. 9 shows the state of using the cellular phone shown in Fig. 8.

In this example, the DRAM is in the low power consumption mode by the control of the CPU when the cellular phone is in the waiting state. At this time, the power consumption of the DRAM is as much as that of the flash memory in the standby state.

When the cellular phone then enters the service state from the waiting state, the CPU raises the CE2 signal shown in Fig. 8 to the high level. After the DRAM entered the idle mode, the data retained in the flash memory are transferred to the DRAM (Fig. 9(a)). During the service state, the DRAM is used as the work memory. Here, the service state includes not only the state of exchanging vocal communications but also the state of transferring data.

When the service state shifts to the waiting state, those, of the data of the DRAM, necessary to be retained are saved in the flash memory (Fig. 9(b)). After this, the CPU lowers the CE2 signal to the low level and enters the DRAM to the low power consumption mode. The DRAM does not perform refresh operation in the low power consumption mode so that the unnecessary data is lost.

When the power supply is switched off, the necessary data are retained in the flash memory. By applying the DRAM of the first embodiment to the work memory of the cellular phone, the power consumption when the cellular phone is in the waiting state is drastically reduced.

Here, the DRAM and the flash memory may be controlled not by the CPU but by a dedicated memory controller or the like. The data transfer may also be done during the service state if necessary not only when the switching over the waiting state and the service state. Moreover, the memory for backing up the data should not be limited to the flash memory but may be an SRAM. The data may be saved in a server such as the base station of the cellular phone.

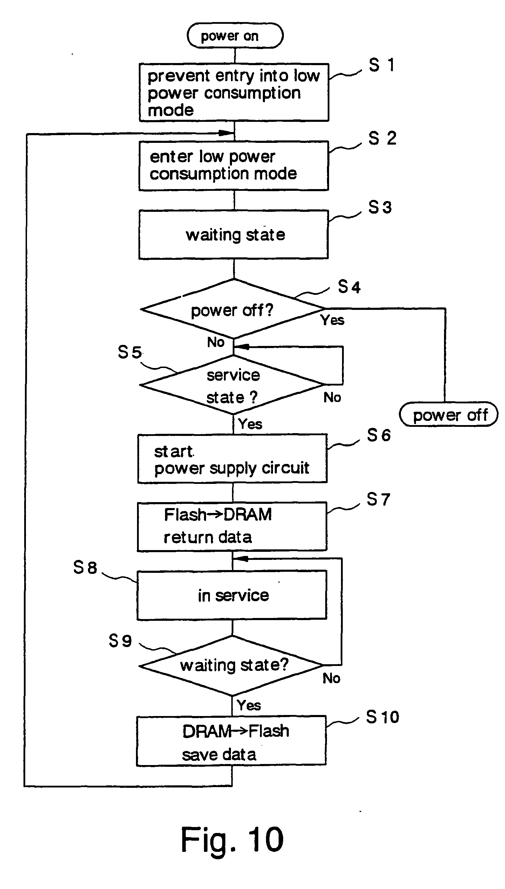

Fig. 10 is a flow chart showing a control of the cellular phone shown in Fig. 8.

At first Step S1 an entry to the low power consumption mode is prevented when the power supply is switched on. As shown in Fig. 7, specifically, the malfunction is prevented during the activation period of the STTCRX signal of the VDD starting circuit 12.

Next, at Step S2, the CPU turns the CE2 signal to the low level to enter the DRAM into the low power consumption mode. At Step S3, the cellular phone is in the waiting state.

Next, at Step S4, the CPU detects whether or not the power supply is switched off. When the power supply is switched off, the procedure is complete. When the power supply is not switched off, the procedure advances to Step S5.

At Step S5, the CPU repeats the waiting state until it becomes the service state. When it becomes the service state, the procedure advances to Step S6.

At Step S6, the CPU raises the CE2 signal to the high level to shift the DRAM from the low power consumption mode to the idle mode. Then, the individual power supply circuits 28, 30, 32 and 34 shown in Fig. 3 are started again.

Next, at Step S7, the CPU transfers the data retained in the flash memory to the DRAM (return the data).

Next, at Step S8, the service or the data transfer is performed.

At Step S9, the CPU detects whether or not the DRAM becomes the waiting state. When it does not, the procedure returns to Step S7. When it does, the procedure advances to Step S10.

At Step S10, the CPU transfers those of the data of the DRAM necessary to be retained, to the flash memory (save the data).

Then, the procedure returns to Step S2, at which the cellular phone enters again the waiting state. The DRAM enters the low power consumption mode.

In one example of a semiconductor memory device and its control method embodying the present invention, the operations of the booster 28, the precharging voltage generator 30, the internal supply voltage generator 32 and the substrate voltage generator 34 are stopped during the low power consumption mode. Therefore, the power consumption in the low power consumption mode can be drastically reduced, as compared with previously-considered devices.

In the low power consumption mode, the boost voltage VPP and the internal supply voltage VII, and the substrate voltage VBB and the precharging voltage VPR are set at the power supply voltage VDD and the ground voltage VSS, respectively. Therefore, the internal circuit of the main circuit unit 20 can be prevented from having the leak path thereby to reduce the power consumption.

By utilizing the CE2 signal existing in the previously-considered devices, the DRAM is entered to the low power consumption mode. Therefore, the kind and the number of the external terminals can be identical to those of the previously-considered terminals. As a result, the user of the DRAM is not required to drastically change the circuit due to adding the low power consumption mode.

When the power supply is switched on, the VDD starter 12 inactivates the start signal STTCRX (to the low level) until the power supply voltage VDD reaches the predetermined voltage. As a result, the low power entry circuit 14 can be prevented from any malfunction when the power supply is switched on, to prevent the ULP signal from being activated and the DRAM from entering the low power consumption mode.

When the power supply is switched on, the CE2 signal is raised to the high level the predetermined time T0 after the power supply voltage VDD reaches the minimum operating voltage VDDmin. This makes it possible to prevent the erroneous entry into the low power consumption mode when the power supply is switched on.

By applying DRAM embodying the present invention to the work memory of the cellular phone, therefore, the power consumption of the cellular phone during the waiting state can be drastically reduced. Moreover, the malfunction can be prevented.

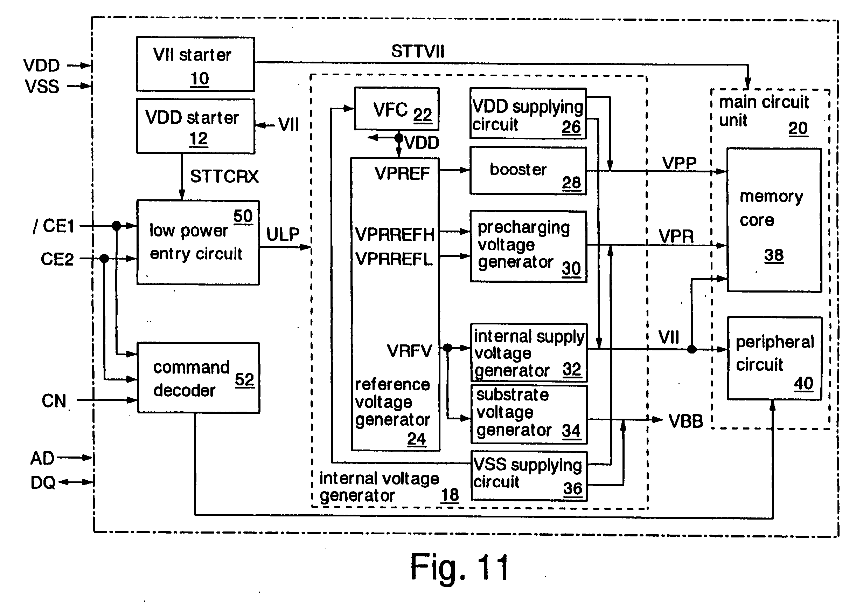

Fig. 11 shows a second embodiment of the semiconductor memory device and its control method of the present invention. The same circuits as those described in the first embodiment are designated by the common reference numerals, and their detailed description will be omitted.

In this embodiment, a low power entry circuit 50 is supplied with the /CE1 signal and the CE2 signal. A command decoder 52 is supplied with the /CE1 signal, the CE2 signal and another control signal CN. The remaining construction is equivalent to that of foregoing first embodiment.

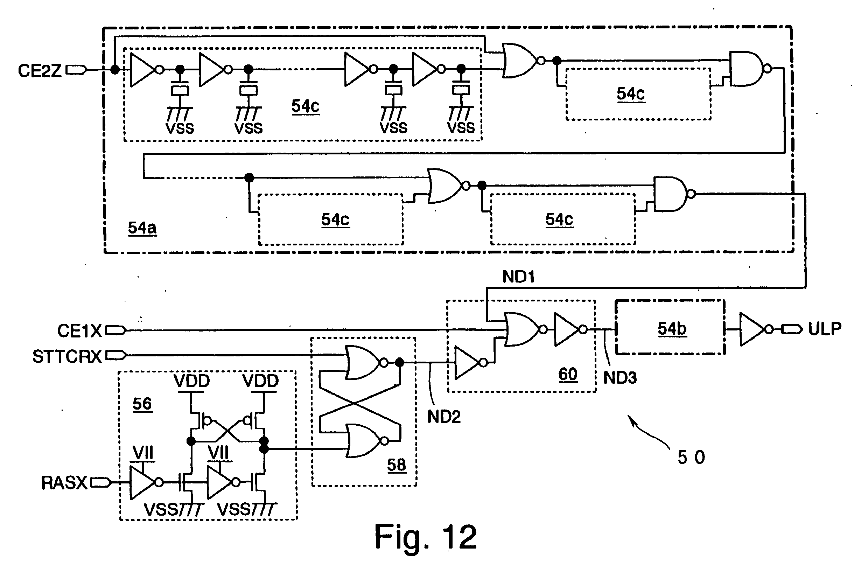

Fig. 12 shows the detail of the low power entry circuit 50.

The low power entry circuit 50 has timing adjusting circuits 54a and 54b, a level shifter 56, an RS flip-flop 58 and a combinational circuit 60.

The timing adjusting circuit 54a is formed by connecting a two-input NOR gate connected at its one input with a delay circuit 54c and a two-input NAND gate connected at its one input with the delay circuit 54c, in plurality in cascade. Each delay circuit 54c has an MOS capacity arranged between a plurality of inverters connected in cascade. The timing adjusting circuit 54a delays the falling edge of a chip enable signal CE2Z by about 100 ns and outputs it to a node ND1. The CE2Z signal is the CE2 signal which is supplied from the exterior and received at the input buffer (not shown).

The timing adjusting circuit 54b is identical to the timing adjusting circuit 54a. The timing adjusting circuit 54b delays the falling edge of the signal transmitted to a node ND3, by about 100 ns.

The level shifter 56 has two sets of pMOSes and nMOSes connected in series. Each nMOS receives at its gate the signals in phase and in inverted phase of a row address strobe signal RASX. The inverter for generating these inverted and uninverted signals of the RASX signal receives the internal supply voltage VII and the ground voltage VSS. The RASX signal is a control signal which turns to a low level when the word line is activated. The gates of the pMOSes are individually connected with the drains of the adjacent pMOSes, and the drains (or output nodes) of the nMOSes for receiving the positive logic of the RASX signal are connected with the RS flip-flop 58. Each pMOS receives the power supply voltage VDD at its source, and each nMOS receives the ground voltage VSS at its source.

The RS flip-flop 58 is composed of two two-input NOR gates. One input corresponding to an output node ND2 receives the start signal STTCRX, and the other input receives the output signal of the level shifter 56.

The combinational circuit 60 receives the low level of the nodes ND1, ND2 and the chip enable signal CE1X and it turns the output node ND3 at the low level. The CE1X signal is generated at the input buffer (not shown) receiving the /CE1 signal supplied from the exterior and is also the negative logic signal.

The timing adjusting circuit 54b activates the ULP signal (to the high level) through the inverter about 100 ns after receiving the low level of the node ND3.

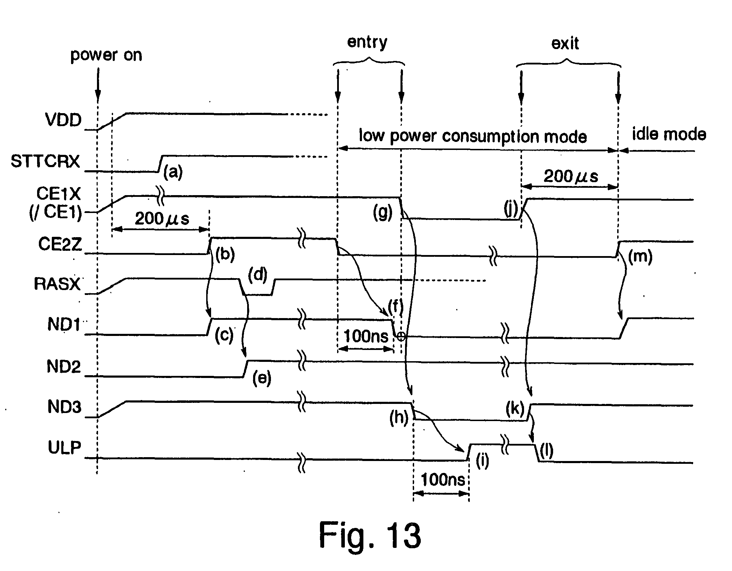

Fig. 13 shows the operations of the low power entry circuit 50.

First, when the power supply is switched on, the STTCRX signal turns to the low level so that the voltage of the /CE1 signal rises following the power supply voltage VDD. Thus, the malfunction is prevented.

A predetermined time after the power supply was switched on, the STTCRX signal turns to the high level (Fig. 13(a)). After this, the exterior controller for controlling the DRAM raises the CE2 signal to the high level (Fig. 13(b)). The timings above are identical to those of the first embodiment. In response to the high level of the CE2Z signal, the node ND1 shown in Fig. 12 turns to the high level (Fig. 13(c)).

The initial cycle is executed to turn the RASX signal to the low level (Fig. 13(d)). In response to the low level of the RASX signal, the RS flip-flop 58 raises the node ND2 to the high level (Fig. 13(e)). After this, there are started the operations of the internal voltage generator 18 shown in Fig. 11.

Next, there is supplied an entry command for the entry into the low power consumption mode. In this embodiment, the DRAM enters the low power consumption mode by turning the /CE1 signal to the low level a predetermined time after turning the CE2 signal to the low level.

The timing adjusting circuit 54a turns the node ND1 to the low level about 100 ns after receiving the low level of the CE2Z signal (Fig. 13(f)). 100 ns or more after the falling edge of the CE2Z signal, the CE1X signal is turned to the low level (Fig. 13(g)). In response to the low level of the CE1Z signal and the low level of the node ND1, the combinational circuit 60 shown in Fig. 12 turns the node ND3 to the low level (Fig. 13(h)). The timing adjusting circuit 54b raises the ULP signal to the high level (Fig. 13(i)) about 100 ns after receiving the low level of the node ND3. The DRAM enters the low power consumption mode.

Thus, the DRAM enters the low power consumption mode by the command input.

At this time, the inverter of the level shifter 56 shown in Fig. 12 receives the power supply voltage VDD in place of the internal supply voltage VII. As a result, the level shifter 56 is prevented to have the leak path because the gate of the nMOS is reliably switched off.

When the low power consumption mode is released, the CE1X signal is first turned to the high level (Fig. 13(j)). The combinational circuit 60 receives the high level of the CE1X signal to turn the node ND3 to the high level (Fig. 13(k)) and the ULP signal to the low level (Fig. 13(l)). 200 is after the rising edge of the CE1X signal, the CE2Z signal is turned to the high level (Fig. 13(m)). In response to the high level of the CE2Z signal, a level of the node ND1 turns to the high level. During this period of 200 s, the internal voltage generator 18 is activated to stabilize the individual internal voltages VPP, VPR, VII and VBB at predetermined levels.

Here, the activations and inactivations of the internal voltage generator 18 are performed as in the first embodiment. Specifically, the controls of the individual circuits in this embodiment are identical to those of the first embodiment excepting that the entry to and exit from the low power consumption mode are executed by the command inputs.

This embodiment can achieve effects similar to those of the foregoing first embodiment. In this embodiment, moreover, the DRAM can enter the low power consumption mode and can be released from the low power consumption mode by the command inputs using the /CE1 signal and the CE2 signal.

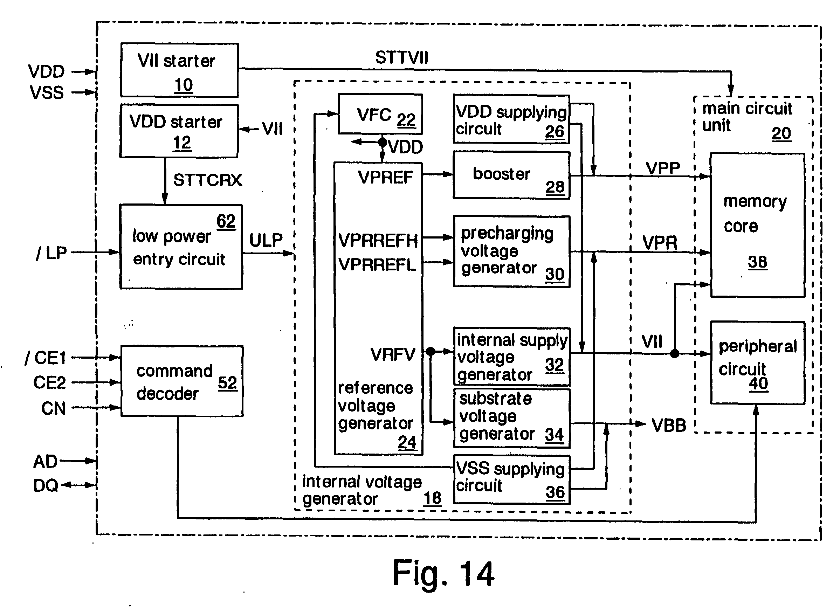

Fig. 14 shows a third embodiment of the semiconductor memory device of the present invention. The same circuits as those described in the first and second embodiments are designated by the common reference numerals, and their detailed description will be omitted. In this embodiment, a low power entry circuit 62 receives the low power consumption mode signal /LP. This low power consumption mode signal /LP is a signal dedicated for the DRAM to enter the low power consumption mode. The low power entry circuit 62 detects the falling edge of the /LP signal to bring the DRAM into the low power consumption mode. The command decoder 52 is supplied with the /CE1 signal, the CE2 signal and another control signal CN. The remaining constructions are similar to those of the foregoing first embodiment.

The operation timings of the DRAM at the switch-on of the power supply and at the entry into and the exit from the low power consumption mode according to this embodiment are identical to those of the case in which the CE2 signal is replaced by the /LP signal in the timing chart shown in Fig. 7.

This embodiment can also achieve effects similar to those of the foregoing first embodiment. In this embodiment, moreover, the DRAM can reliably enter the low power consumption mode and be released from the mode by the dedicated low power consumption mode signal /LP.

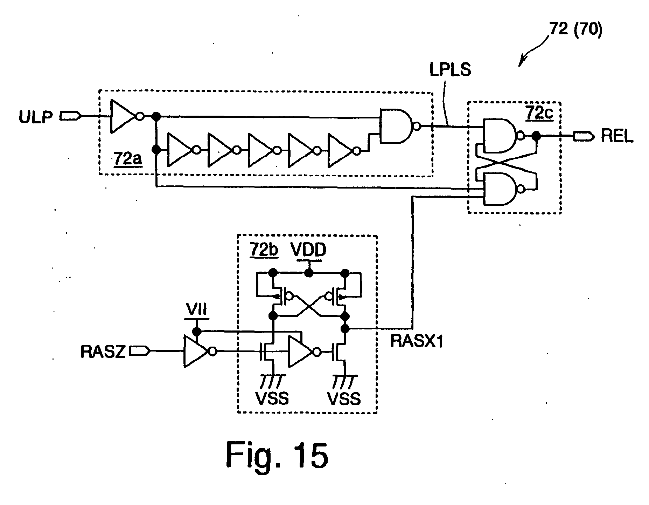

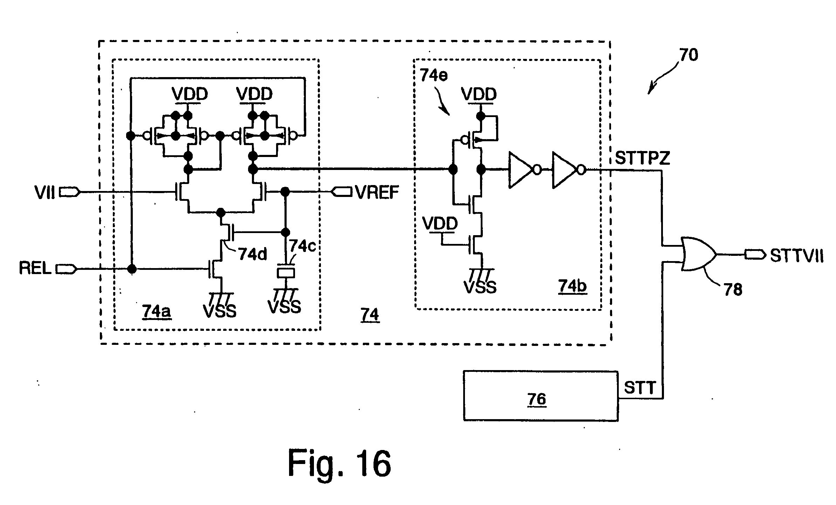

Figs. 15 and 16 show a VII starter in a fourth embodiment of the semiconductor memory device and a third embodiment of its control method of the present invention. The same circuits as those described in the first embodiment are designated by the common reference numerals, and their detailed description will be omitted.

In this embodiment, a VII starter 70 is formed in replace of the VII starter 10 in Fig. 3 (the first embodiment). The other configuration is identical to that in Fig. 3. In other words, the DRAM of this embodiment similar to that of Fig. 7 enters the low power consumption mode by turning the CE2 signal to low level during a high-level period of the /CE1 signal and it is released from the low power consumption mode by turning the CE2 signal to high level.

The VII starter 70 comprises a release detecting circuit 72 shown in Fig. 15 , a level detecting circuit 74, and a power-on circuit 76 shown in Fig. 16. In Figs. 15 and 16, a logic circuit is supplied with a power supply voltage VDD except the circuit with a power supply voltage indicated.

A release detecting circuit 72 comprises a detecting circuit 72a, a level shifter 72b, and a flip-flop 72c. The detecting circuit 72a receives a low power signal ULP shown in Fig. 3 and outputs the low level of a pulse LPLS in synchronization with the falling edge of the ULP signal. The level shifter 72b converts the high level voltage (internal power supply voltage VII) of a row address strobe signal RASZ to the external power supply voltage VDD and outputs a row address strobe signal RASX1 having inverted logic. The level shifter 72b is identical to the level shifter 56 shown in Fig. 12. Receiving a low pulse from the detecting circuit 72a, the flip-flop 72c turns a release signal REL to high level, and receiving a low level (RASZ = high level) from the level shifter 72b, it turns the release signal REL to low level.

In Fig. 16, a level detecting circuit 74 comprises a differential amplifier 74a including a current mirror circuit and an inverter row 74b which includes an odd number of inverters and receives the output of the differential amplifier 74a. The differential amplifier 74a is activated during the high level of the release signal REL, compares an internal power supply voltage VII with a reference voltage VREF, and outputs the comparison result to an inverter row 74b. A generator for the internal power supply voltage VII generates a constant value of the internal power supply voltage VII independent of the fluctuation of the power supply voltage VDD supplied from the exterior. On the other hand, the reference voltage VREF varies depending on the fluctuation of the power supply voltage VDD.

The output voltage of the differential amplifier 74a goes low when the internal power supply voltage VII is lower than the reference voltage VREF. The differential amplifier 74a comprises a MOS capacitor 74c for receiving the reference voltage VREF in order to prevent its response to insignificant fluctuation of the reference voltage VREF. In addition, an nMOS 74d for receiving the reference voltage VREF is disposed on a path to a ground line VSS in order to limit the amount of current flow to the ground line VSS and reduce the power consumption during the operation of the differential amplifier 74a. The nMOS 74d operates as high-resistance. An inverter 74e in the initial stage of the inverter row 74b has an nMOS connected in serial so as to have the logic threshold of an input signal in conformity with the output of the differential amplifier 74a.

A power-on circuit 76 turns a start signal STT to high level during a predetermined period since the power supply voltage is supplied to the DRAM. An OR circuit 78, upon receiving the high level of a start signal STTPZ or the high level of the start signal STT, outputs the high level of a start signal STTVII (reset signal). The start signal STTVII, similarly to that of Fig. 3, is supplied to the main circuit unit 20 and initializes a predetermined internal circuit.

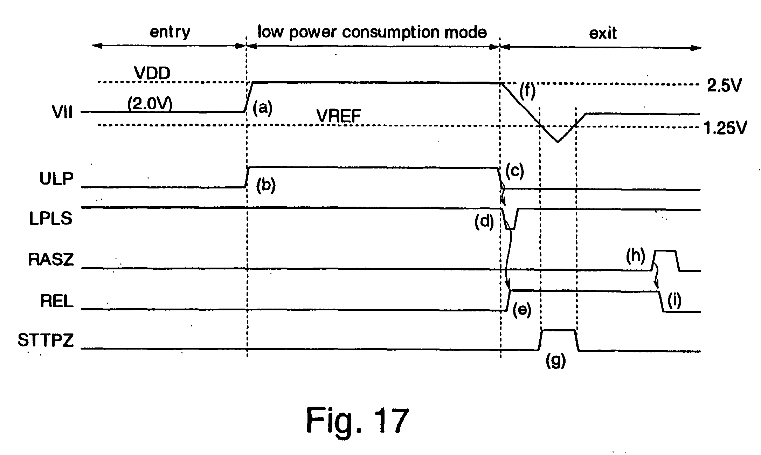

Fig. 17 shows the operation timings of the above-described DRAM at the time of entry to and exit from the low power consumption mode.

Firstly, when the CE2 signal (not shown) is turned to low level, the DRAM enters the low power consumption mode by a low power entry circuit 14 shown in Fig. 3 and a generator for the internal power supply voltage VII terminates its operation. The internal power supply voltage VII (for example, 2.0V in a normal operation) becomes equal to the power supply voltage VDD (for example, 2.5V)(Fig. 17(a)) and an ULP signal turns to high level(Fig. 17(b)).

Subsequently, the CE2 signal being turned to high level, the DRAM is released from the low power consumption mode and the ULP signal turns to low level(Fig. 17(c)). In other words, the DRAM is released from the low power consumption mode in accordance with the level of the CE2 signal received during the low power consumption mode. The exit from the low power consumption mode is controlled by the low power entry circuit 14 shown in Fig. 3.

Receiving the falling edge of the ULP signal, the detecting circuit 72a in Fig. 15 turns an LPLS signal to low level (pulse)(Fig. 17(d)). Receiving the low level of the LPLS signal, the flip-flop 72c in Fig. 15 turns the REL signal to high level (Fig.17 (e)).

Due to the exit from the low power consumption mode, a power supply line of the internal power supply voltage VII and that of the power supply voltage VDD are disconnected and simultaneously the generator for the internal power supply voltage VII initiates its operation. The internal power supply voltage VII goes low for some time from the initiation of the generator(Fig. 17(f)). The differential amplifier 74a in Fig.16 outputs low level to the inverter row 74b when the internal power supply voltage VII is lower than the reference voltage VREF(for example, 1.25V). The inverter row 74b, upon receiving the low level of the differential amplifier 74a, outputs the high level of the STTPZ signal(Fig. 17(g)). The OR circuit 78, upon receiving the high level of the STTPZ signal, turns a start signal STTVII to high level. The start signal STTVII functions as a reset signal and a predetermined internal circuit of the main circuit unit 20 shown in Fig.3 is initialized.

After the exit from the low power consumption mode, by issuing an operation command to the DRAM, the RASZ signal is turned to high level(Fig. 17(h)) and the REL signal to low level(Fig. 17(i)). The differential amplifier 74a is inactivated due to the low level of the REL signal.

As described above, at the time of the exit from the low power consumption mode, the initialization of the internal circuit prevents it from malfunctioning when the operation of the internal circuit supplied with the internal power supply voltage VII cannot be ensured because of the internal power supply voltage VII lower than a predetermined voltage (reference voltage VREF).

In this embodiment above, when the state of the CE2 signal received during the low power consumption mode indicates exit of the low power consumption mode, the low power consumption mode is released. This allows the easy exit of a chip from the low power consumption mode by the control signal from the exterior.

At the exit from the low power consumption mode, the start signal STTVII which is a reset signal for initializing an internal circuit is activated during a period where the internal power supply voltage VII is lower than the reference voltage VREF. This makes it possible to securely reset the internal circuit and prevent the malfunction of the internal circuit when the low power consumption mode shifts to the normal operating mode.

One control signal(CE2 signal)enables the entry of a chip to the low power consumption mode and the exit of a chip from the low power consumption mode.

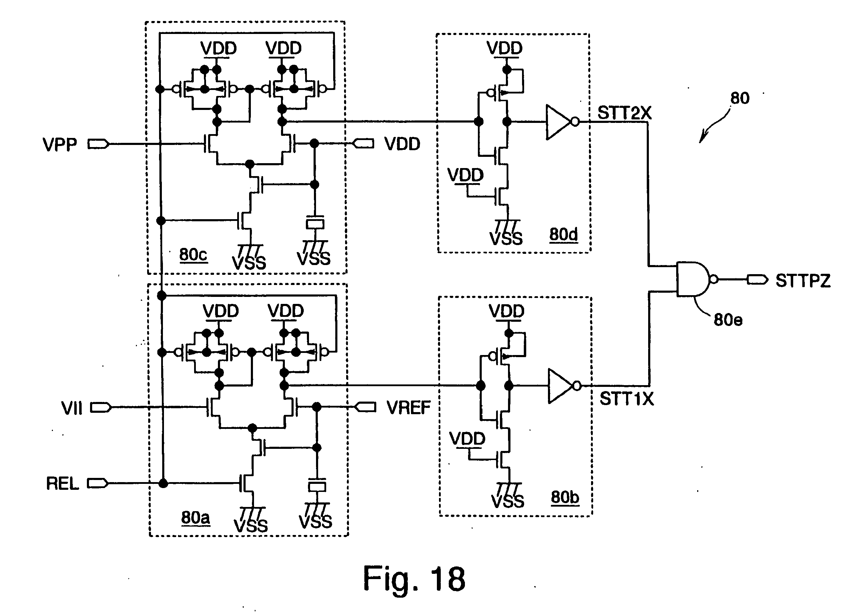

Fig. 18 shows a level detecting circuit 80 in a fifth embodiment of the semiconductor memory device and its control method of a fourth embodiment of the present invention. The same circuits as those described in the first and forth embodiments are designated by the common reference numerals, and their detailed description will be omitted.

In this embodiment, a level detecting circuit 80 is formed in replace of the level detecting circuit 74 described in the forth embodiment. The other configuration is identical to that in the forth embodiment.

The level detecting circuit 80 comprises: a differential amplifier 80 for comparing the internal power supply voltage VII with the reference voltage VREF; an inverter row 80b including an even number of inverters; a differential amplifier 80c for comparing a boost voltage VPP of a word line (not shown) with the power supply voltage VDD from the exterior; an inverter row 80d including an even number of inverters; and an NAND gate 80e. The boost voltage VPP generated by a booster is formed inside of the chip. The differential amplifiers 80a and 80c are identical to the differential amplifier 74a in Fig. 16 and are activated upon receipt of the high level of the REL signal. The inverter rows 80b and 80d are constructed of the inverter in the initial stage and the inverter in the second stage of the inverter row 74b in Fig. 16. The inverter row 80b receives the output of the differential amplifier 80a and outputs the received logic level to a NAND gate 80e as a start signal STT1X. The inverter row 80d receives the output of the differential amplifier 80c and outputs the received logic level to the NAND gate 80e as a start signal STT2X. The NAND gate 80e operates as an OR circuit of negative logic and outputs a start signal STTPZ.

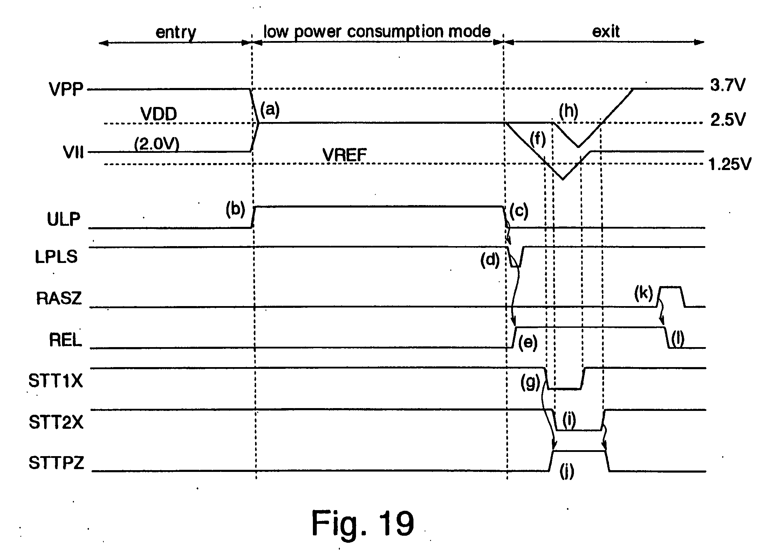

Fig. 19 shows the operation timings of the above-described DRAM at the time of entry to and exit from a low power consumption mode.

Firstly, when the CE2 signal(not shown) is turned to low level, the DRAM enters the low power consumption mode and a generator for the internal power supply voltage VII and a generator for the boost voltage VPP terminate their operation. The internal power supply voltage VII (for example, 2.0V in the normal operation) and the boost voltage VPP (for example, 3.7V in the normal operation) become equal to the power supply voltage VDD (for example, 2.5V)(Fig. 19(a)) and an ULP signal turns to high level (Fig. 18(b)).

Subsequently, the CE2 signal being turned to high level, the DRAM is released from the low power consumption mode and the ULP signal turns to low level (Fig. 19(c)). The LPLS signal is turned to low level (pulse) as well as in Fig. 17 (Fig. 19(d)) and the REL signal is turned to high level (Fig. 19(e)).

Due to the exit from the low power consumption mode, the power supply line of the internal power supply voltage VII and the power supply line of the power supply voltage VDD are disconnected and the generator for the internal power supply voltage VII initiates its operation. The internal power supply voltage VII goes low for some time from the initiation of the generator(Fig. 19(f)). The low level of the STT1X signal is output during a period where the internal power supply voltage VII is lower than the reference voltage VREF (for example, 1.25V) (Fig. 19(g)). Similarly, the connection between the power supply line of the boost voltage VPP and that of the power supply voltage VDD is disconnected and the generator for the boost voltage VPP initiates its operation. The boost voltage VPP goes low for some time from the initiation of the generator (Fig. 19(h)). The low level of the STT2X signal is output during a period where the boost voltage VPP is lower than the power supply voltage VDD (Fig. 19(i)).

The NAND gate 80e in Fig. 18 outputs the high level of the STTPZ signal during a period where the STT1X signal or the STT2X signal is at low level (Fig. 19(j)). During the high level of the STTPZ signal, the start signal STTVII (Fig. 16)is turned to high level. The start signal STTVII functions as a reset signal and initializes a predetermined internal circuit of the main circuit unit 20 shown in Fig.3.

After the exit from the low power consumption mode, the DRAM initiates its operation, thereby the RASZ signal being turned to high level (Fig. 19(k)) and the REL signal to low level(Fig. 19(l)) as well as in Fig. 17. The differential amplifier 80a and 80 are inactivated due to the low level of the REL signal.

This embodiment can also achieve effects similar to those of the foregoing fourth embodiment. In this embodiment, moreover, at the time of the exit from the low power consumption mode a start signal STTVII for initializing an internal circuit is activated during a period where the boost voltage VPP internally generated is lower than the power supply voltage VDD from the exterior. Specifically, at the time of the exit from the low power consumption mode, the start signal STTVII for initializing an internal circuit is activated during a period where at least one of the internal power supply voltage VII and is/are respectively lower than the reference voltage VREF and the power supply voltage VDD. This makes it possible to securely reset the internal circuit and prevent the malfunction of the internal circuit when the low power consumption mode shifts to the normal operating mode.

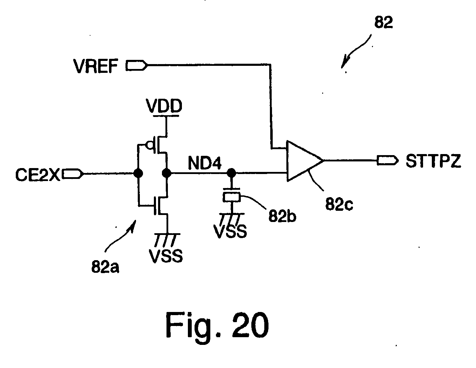

Fig. 20 shows a start signal generator of the semiconductor memory device in a sixth embodiment and its control method of a fifth embodiment of the present invention. The same circuits as those described in the first and forth embodiments are designated by the common reference numerals, and their detailed description will be omitted.

In the DRAM of this embodiment, a start signal generator 82 is formed in replace of the release detecting circuit 72 and the level detecting circuit 74 described in the forth embodiment. The other configuration is identical to that in Fig.3 (the first embodiment).

The start signal generator 82 are constructed of a CMOS inverter 82a for receiving a CE2X signal (internal signal) which is an inverted CE2 signal, a MOS capacitor 82b connected with the output of the CMOS inverter 82a, and a differential amplifier 82c for receiving the input of the CMOS inverter 82a and the reference voltage VREF. The differential amplifier 82c comprising a current mirror circuit, turns a start signal STTPZ to high level when the voltage of a node ND4 is lower than the reference voltage VREF.

The pMOS of the CMOS inverter 82a has a long channel length to have high on-resistance. A CR time constant circuit is constructed of the pMOS of the CMOS inverter 82a and the MOS capacitor 82b. Utilizing the on-resistance of a transistor to construct the CR time constant circuit allows the layout to be reduced in size than the case of utilizing diffused resistance.

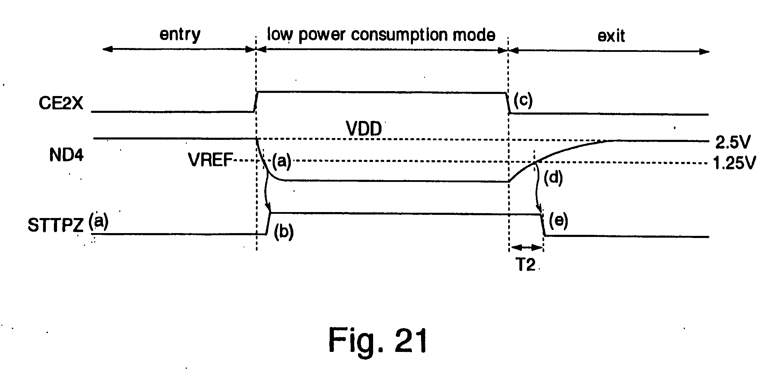

Fig. 21 shows the operation timings of the above-described DRAM at the time of entry to and exit from the low power consumption mode.

Firstly, when the CE2 signal (not shown) is turned to low level, the CE2X signal is turned to high level and the DRAM enters the low power consumption mode. A generator for the internal power supply voltage VII and a generator for the boost voltage VPP terminate their operation. The CMOS inverter 82a in Fig. 20 upon receiving the high level of the CE2X signal, turns the nMOS on and a node ND4 to low level (Fig. 21(a)). The differential amplifier 82c turns a STTPZ signal to high level when the voltage of the node ND4 is lower than the reference voltage VREF (Fig. 21(b)).

Subsequently, the CE2 signal being turned to high level and the CE2X signal to low level, the DRAM is released from the low power consumption mode (Fig. 21(c)). The CMOS inverter 82 in Fig. 20 upon receiving the low level of the CE2X signal, turns the pMOS on and the node ND4 to high level (Fig. 21 (d)). At this time the voltage of the node ND4 gradually rises in accordance with the time constant determined by the on-resistance of the pMOS and the CMOS capacitor. The differential amplifier 82c turns the STTPZ signal to low level when the voltage of the node ND4 is higher than the reference voltage VREF (Fig. 21(e)).

Consequently, the STTPZ signal(reset signal) is activated (high level) and the internal circuit is initialized during a period T2 from the exit from the low power consumption mode. The period T2 is set after the exit from the low power consumption mode in correspondence with a period where the internal power supply voltage VII is lower than a predetermined voltage so that the operation of the internal circuit supplied with the internal power supply voltage VII can not be ensured. In other words, the start signal generator 82 operates as a timer for determining the length of the period T2.

This embodiment can also achieve effects similar to those of the foregoing fourth embodiment. In this embodiment, moreover, at the time of the exit from the low power consumption mode the start signal generator 82 is operated as a timer to generate the STTPZ signal and the internal circuit is initialized during the period T2 after the exit from the low power consumption mode. This makes it possible to reliably reset the internal circuit and prevent the malfunction of the internal circuit when the low power consumption mode shifts to the normal operating mode.

Since the start signal generator 82 is operated as a CR time constant circuit, it is possible to set the period T2 based on the propagation delay time of a signal propagated to the CR time constant circuit. This makes it possible to set a period necessary for resetting the internal circuit by a simple circuit.

The on-resistance of the pMOS is utilized to form the CR time constant circuit so that the layout of the start signal generator 82 can be reduced in size.

In the embodiment described above, the present invention is applied to the DRAM. However, the present invention is not limited to this embodiment. For example, the present invention may be applied to a semiconductor memory such as SDRAMs (Synchronous DRAMs), DDR SDRAMs (Double Data Rate SDRAMs), or FCRAMs (Fast Cycle RAMs).

A semiconductor fabrication process to which the present invention is applied is not restricted to the CMOS process, but it may well be a Bi-CMOS process.

The foregoing second embodiment has been described on an example in which the low power entry circuit 50 is formed by connecting the plurality of delay circuits 54c in series. However, the present invention should not be limited thereto but may form the low power entry circuit by using a latch circuit to be controlled by the STTCRX signal, for example. In this modification, the circuit scale is reduced.

The foregoing third embodiment has been described on the example using the dedicated low power consumption mode signal /LP. This DRAM can be supplied even to the user requiring no low power consumption mode, for example, by pulling up the /LP signal on the chip and providing no terminal for the /LP signal. This /LP signal may be connected with the power supply voltage VDD by bonding or blowing the fuse. Alternatively, the /LP signal may be connected with the power supply voltage VDD by selecting photo masks of a wiring layer.

The foregoing fifth embodiment has been described on an example of the comparison between the boost voltage VPP and the power supply voltage VDD. However, the present invention is not limited to this embodiment, for example, the boost voltage VPP may well be compared with the reference voltage VREF which is generated by stepping down the power supply voltage VDD.

The foregoing sixth embodiment has been described on an example of operating the start signal generator 82 as a timer for determining the length of the period T2 at the exit from the low power consumption mode and activating a STTPZ signal(reset signal) for initializing an internal circuit during the period T2. The present invention is not limited to this embodiment. For example, at the time of the exit from the low power consumption mode, a counter operating in normal operation is operated as a timer so as to count a predetermined number. The reset signal for initializing an internal circuit may well be activated during a period where the counter counts the number. A refresh counter indicating the refresh address of memory cells or the like can be used as the counter.

The invention is not limited to the above embodiments and various modifications may be made without departing from the scope of the invention. Any improvement may be made in part or all of the components.

## Claims

1. A method of operating a semiconductor memory including dynamic memory cells, having a low power consumption mode, in which the dynamic memory cells do not retain data therein by prohibiting refresh operations, the semiconductor memory **characterised by** comprising the steps of
entering the low power consumption mode in response to an external control signal received at an external terminal; and
receiving a power supply voltage continuously during the low power consumption mode.

2. The method of operating a semiconductor memory according to claim 1, in which
the external control signal is a dedicated external control signal (/LP).

3. The method of operating a semiconductor memory according to claim 1, in which
the external control signal is an external command which comprises a combination of a plurality of control signals (/CE1, CE2).

4. The method of operating a semiconductor memory according to claim 3, in which
the memory enters the low power consumption mode during the idle mode.

5. The method of operating a semiconductor memory according to claim 4, further comprising the step of
exiting from the low power consumption mode in response to a second command.

6. The method of operating a semiconductor memory according to claim 5, in which
the memory is initialized after the exit from the low power consumption mode.

7. The method of operating a semiconductor memory according to claim 2, in which
the semiconductor memory enters the low power consumption mode in response to a voltage change of the dedicated external control signal from a first voltage to a second voltage.

8. The method of operating a semiconductor memory according to claim 7, in which
the low power consumption mode is maintained while the dedicated external control signal has the second voltage.

9. The method of operating a semiconductor memory according to claim 8, in which
the semiconductor memory exits the low power consumption mode in response to a reverse voltage change of the dedicated external control signal from the second voltage to the first voltage.

10. A memory system comprising:
a first memory including dynamic memory cells, having a low power consumption mode in which the dynamic memory cells do not retain data therein by prohibiting refresh operations, and the first memory having a data terminal; and
a second memory including flash memory cells, having a data terminal which is connected with the data terminal of the first memory, **characterised in that**
the first memory enters the low power consumption mode in response to an external control signal (CE2, /LP) received at an external terminal and continuously receives a power supply voltage during the low power consumption mode.

11. The memory system according to claim 10, in which
data stored in the dynamic memory cells in the first memory is transferred to the flash memory cells in the second memory before the first memory enters the low power consumption mode.

12. The memory system according to claims 10 or 11, in which
data stored in the flash memory cells in the second memory is transferred to the dynamic memory cells in the first memory after the first memory exits the low power consumption mode.

## Patentansprüche

1. Operationsverfahren eines Halbleiterspeichers, der dynamische Speicherzellen enthält und einen Modus des niedrigen Energieverbrauchs hat, in dem die dynamischen Speicherzellen durch das Verhindern von Auffrischoperationen keine Daten halten, welcher Halbleiterspeicher **dadurch gekennzeichnet ist, dass** er die Schritte umfasst zum
Eintreten in den Modus des niedrigen Energieverbrauchs als Reaktion auf ein externes Steuersignal, das an einem Außenanschluss empfangen wird; und
kontinuierlichen Empfangen einer Energiezufuhrspannung während des Modus des niedrigen Energieverbrauchs.

2. Operationsverfahren eines Halbleiterspeichers nach Anspruch 1, bei dem
das externe Steuersignal ein dediziertes externes Steuersignal (/LP) ist.

3. Operationsverfahren eines Halbleiterspeichers nach Anspruch 1, bei dem
das externe Steuersignal ein externer Befehl ist, der eine Kombination aus einer Vielzahl von Steuersignalen (/CE1, CE2) umfasst.

4. Operationsverfahren eines Halbleiterspeichers nach Anspruch 3, bei dem
der Speicher während des Leerlaufmodus in den Modus des niedrigen Energieverbrauchs eintritt.

5. Operationsverfahren eines Halbleiterspeichers nach Anspruch 4, ferner mit dem Schritt zum
Austreten aus dem Modus des niedrigen Energieverbrauchs als Reaktion auf einen zweiten Befehl.

6. Operationsverfahren eines Halbleiterspeichers nach Anspruch 5, bei dem
der Speicher nach dem Austritt aus dem Modus des niedrigen Energieverbrauchs initialisiert wird.

7. Operationsverfahren eines Halbleiterspeichers nach Anspruch 2, bei dem
der Halbleiterspeicher in den Modus des niedrigen Energieverbrauchs als Reaktion auf eine Spannungsveränderung des dedizierten externen Steuersignals von einer ersten Spannung in eine zweite Spannung eintritt.

8. Operationsverfahren eines Halbleiterspeichers nach Anspruch 7, bei dem
der Modus des niedrigen Energieverbrauchs beibehalten wird, während das dedizierte externe Steuersignal die zweite Spannung hat.

9. Operationsverfahren eines Halbleiterspeichers nach Anspruch 8, bei dem
der Halbleiterspeicher aus dem Modus des niedrigen Energieverbrauchs als Reaktion auf eine umgekehrte Spannungsveränderung des dedizierten externen Steuersignals von der zweiten Spannung in die erste Spannung austritt.

10. Speichersystem mit:
einem ersten Speicher, der dynamische Speicherzellen enthält und einen Modus des niedrigen Energieverbrauchs hat, in dem die dynamischen Speicherzellen durch das Verhindern von Auffrischoperationen keine Daten halten, welcher erste Speicher einen Datenanschluss hat; und
einem zweiten Speicher, der Flash-Speicherzellen enthält und einen Datenanschluss hat, der mit dem Datenanschluss des ersten Speichers verbunden ist, **dadurch gekennzeichnet, dass**
der erste Speicher in den Modus des niedrigen Energieverbrauchs als Reaktion auf ein externes Steuersignal (CE2, /LP) eintritt, das an einem Außenanschluss empfangen wird, und während des Modus des niedrigen Energieverbrauchs kontinuierlich eine Energiezufuhrspannung empfängt.

11. Speichersystem nach Anspruch 10, bei dem
Daten, die in den dynamischen Speicherzellen in dem ersten Speicher gespeichert sind, zu den Flash-Speicherzellen in dem zweiten Speicher übertragen werden, bevor der erste Speicher in den Modus des niedrigen Energieverbrauchs eintritt.

12. Speichersystem nach Anspruch 10 oder 11, bei dem
Daten, die in den Flash-Speicherzellen in dem zweiten Speicher gespeichert sind, zu den dynamischen Speicherzellen in dem ersten Speicher übertragen werden, nachdem der erste Speicher aus dem Modus des niedrigen Energieverbrauchs austritt.

## Revendications

1. Procédé de fonctionnement d'une mémoire à semi-conducteurs comprenant des cellules de mémoire dynamiques, ayant un mode faible consommation d'énergie, dans lequel les cellules de mémoire dynamiques ne conservent pas les données en empêchant les opérations de rafraîchissement, la mémoire à semi-conducteurs étant **caractérisée en ce qu'**elle comprend les étapes consistant à
entrer dans le mode faible consommation d'énergie en réponse à un signal de commande extérieur reçu au niveau d'une borne extérieure ; et
recevoir une tension d'alimentation en continu pendant le mode faible consommation d'énergie.

2. Procédé de fonctionnement d'une mémoire à semi-conducteurs selon la revendication 1, dans lequel
le signal de commande extérieur est un signal de commande extérieur spécialisé (/LP).

3. Procédé de fonctionnement d'une mémoire à semi-conducteurs selon la revendication 1, dans lequel
le signal de commande extérieur est une commande extérieure qui comprend une combinaison d'une pluralité de signaux de commande (/CE1, CE2).

4. Procédé de fonctionnement d'une mémoire à semi-conducteurs selon la revendication 3, dans lequel
la mémoire entre dans le mode faible consommation d'énergie pendant le mode inactif.

5. Procédé de fonctionnement d'une mémoire à semi-conducteurs selon la revendication 4, comprenant en outre l'étape consistant à
quitter le mode faible consommation d'énergie en réponse à une seconde commande.

6. Procédé de fonctionnement d'une mémoire à semi-conducteurs selon la revendication 5, dans lequel
la mémoire est initialisée après la sortie du mode faible consommation d'énergie.

7. Procédé de fonctionnement d'une mémoire à semi-conducteurs selon la revendication 2, dans lequel
la mémoire à semi-conducteurs entre dans le mode faible consommation d'énergie en réponse à un changement de tension du signal de commande extérieur spécialisé, passant d'une première tension à une seconde tension.

8. Procédé de fonctionnement d'une mémoire à semi-conducteurs selon la revendication 7, dans lequel
le mode faible consommation d'énergie est maintenu alors que le signal de commande extérieur spécialisé présente la seconde tension.

9. Procédé de fonctionnement d'une mémoire à semi-conducteurs selon la revendication 8, dans lequel
la mémoire à semi-conducteurs quitte le mode faible consommation d'énergie en réponse à un changement de tension inverse du signal de commande extérieur spécialisé, passant de la seconde tension à la première tension.

10. Système de mémoire comprenant :
une première mémoire comprenant des cellules de mémoire dynamiques, ayant un mode faible consommation d'énergie dans lequel les cellules de mémoire dynamiques ne conservent pas les données en empêchant les opérations de rafraîchissement, et la première mémoire comportant une borne de données ; et
une seconde mémoire comprenant des cellules de mémoire flash, comportant une borne de données qui est raccordée à la borne de données de la première mémoire, **caractérisé en ce que**
la première mémoire entre dans le mode faible consommation d'énergie en réponse à un signal de commande extérieur (CE2, /LP) reçu au niveau d'une borne extérieure et reçoit en continu une tension d'alimentation pendant le mode faible consommation d'énergie.

11. Système de mémoire selon la revendication 10, dans lequel
les données stockées dans les cellules de mémoire dynamiques de la première mémoire sont transférées vers les cellules de mémoire flash de la seconde mémoire avant que la première mémoire n'entre dans le mode faible consommation d'énergie.

12. Système de mémoire selon la revendication 10 ou 11, dans lequel
les données stockées dans les cellules de mémoire flash de la seconde mémoire sont transférées vers les cellules de mémoire dynamiques de la première mémoire une fois que la première mémoire a quitté le mode faible consommation d'énergie.
